Europäisches Patentamt

European Patent Office

Office européen des brevets

(11) Publication number: **0 233 235**
**B1**

# EUROPEAN PATENT SPECIFICATION

(45) Date of publication of patent specification: **02.01.91**

(51) Int. Cl.⁵: **G 01 N 24/08**

(21) Application number: **86904857.9**

(22) Date of filing: **31.07.86**

(86) International application number:
**PCT/GB86/00457**

(87) International publication number:
**WO 87/00923 12.02.87 Gazette 87/04**

(54) **CENTRALLY ORDERED PHASE ENCODING.**

(30) Priority: **09.08.85 US 764439**
**30.09.85 US 782075**
**15.11.85 US 798551**

(43) Date of publication of application:
**26.08.87 Bulletin 87/35**

(45) Publication of the grant of the patent:
**02.01.91 Bulletin 91/01**

(84) Designated Contracting States:
**DE GB NL**

(56) References cited:
**EP-A-0 117 725**
**EP-A-0 130 479**
**EP-A-0 167 350**
**EP-A-0 172 345**

**Medical Physics, vol. 12, no. 2, March/April
1985, (New York, US), M.L. Wood et al.: "RM
image artifacts from periodic motion", pages
143-151**

(73) Proprietor: **PICKER INTERNATIONAL, INC.
595 Miner Road
Highland Heights Ohio 44143 (US)**

(72) Inventor: **HAACKE, Mark, E.
2312 Glendon Road
University Heights, OH 44118 (US)**
Inventor: **KERSHAW, Carolyn, A.
18-8 Meadowlawn
Mentor, OH 44060 (US)**
Inventor: **PATRICK, John, L.
34680 Sherwood Drive
Solon, OH 44139 (US)**

(74) Representative: **Pope, Michael Bertram Wingate
Central Patent Department Wembley Office The
General Electric Company, p.l.c. Hirst Research
Centre East Lane
Wembley Middlesex HA9 7PP (GB)**

Courier Press, Leamington Spa, England.

## Description

Background of the Invention

The present invention relates to the art of nuclear magnetic resonance. Particular application is found in conjunction with magnetic resonance imaging in regions of a patient undergoing periodic respiratory movement and description will be made with reference thereto. It is to be appreciated, however, that the present invention is also applicable to monitoring other objects which have moving portions, such as imaging regions of a patient adjacent the heart, regions with periodic cardiovascular expansion and contraction, regions with spasmodic muscular action, and other regions of animate and inanimate objects with moving portions or components.

Heretofore, magnetic resonance imaging included positioning the patient in a strong, substantially uniform, longitudinal magnetic field. Magnetic dipoles were cause to precess, generating magnetic resonance signals. Various known techniques have been utilized to select a region of the patient to be imaged and are well known in the art. Magnetic field gradients were applied orthogonally to encode spatial position into a selected slice or planar regions of interest. The magnetic field gradients were encoded along one axis giving a frequency which varied linearly in accordance with position and along an orthogonal axis giving a phase that varied linearly in accordance with position.

The resonance signal was collected with each of a plurality of phase encoding and transformed from a frequency and phase domain to an image or spatial domain. In the image domain, each transformed resonance signal produced a view representing the density of resonating nuclei in each pixel or incremental area of the image region. The amplitude of the phase encoding gradient was incrementally increased with equal steps from view to view to collect a plurality of views, commonly on the order of 128 views. The plurality of views were transformed to create an image representing the density of resonating nuclei in each pixel or incremental area of the image region.

When a portion of the patient or object in the image region was moving, the movement tended to cause a blurring in the resultant image. However, in conventional Fourier transform reconstruction imaging, the blur was not limited to the moving portions. Rather, the distortion was spread across the entire picture in the phase encoding direction. This blurring was commonly manifested in the resultant image as "ghost" artifacts or multiple superimposed coherent image replications along the phase encoding direction or as distributed noise. Moreover, there was an effective periodicity between the respiratory movement and phase encoding gradient over the full image collection cycle. The periodicity enhanced multiple superimposed coherent ghosting. These effects are described in an article appearing at pages 143 to 151 of Medical Physics, volume 12, No. 2, March/April 1985, (New York, US), by M. L. Wood et al entitled "MR Image Artifacts from Periodic Motion".

One solution to respiratory motion artifacts was to gate view collection in accordance with the respiratory cycle. That is, data were only generated when the respiratory movement was at some fixed value, usually near its minimum. A first plurality or views were taken starting with the minimum, negative phase encoding gradient and incrementing upward during a first period of minimum respiratory movement. When the respiratory motion increased beyond a preselected value, the phase encoding and data collection were terminated until the next respiratory cycle. Successive pluralities of phase encoded views were taken in each subsequence minimum movement period. This process was continued until data were collected with a maximum, positive phase encoding gradient, commonly 128 views later. Disruption in data collection during periods of greater respiratory movement or a change in the pattern of respiration increased the duration required to generate an image. One such method is described in EP—A—117725.

A second solution was to reorder the data to reduce the periodicity of the motion. The loss of image resolution and ghosting attributable to respiratory movement has been reduced by negating the effective periodicity of the respiratory motion. Specifically, the phase encoding gradient values were re-ordered such that at the minimum motion portion of the respiratory cycle, the collected view was phase encoded with the maximum or negative most phase encoding gradient; during the maximum respiratory movement, the collected view was phase encoded with a maximum or positive most phase encoding gradient. Commonly, the minimum phase encoding gradient and the maximum phase encoding gradient were encoded at generally the same spatial frequency but with one delayed and the other advanced such that the minimum phase encoding gradient was negative and the maximum phase encoding gradient was positive. Between the minimum and maximum points of motion the phase was encoded in a linearly proportional relationship between phase encoding gradient and rate or degree of respiratory motion. The median degree of motion midway between the extremes was encoded with a central phase encoding, commonly at the lowest spatial frequency. In this manner, the motion-induced artifacts were reduced by converting the periodicity effectively into a single respiratory period.

One of the drawbacks of this re-ordering scheme was that the data collected during the greatest and the least rates of motion were both encoded at the highest spatial frequencies. Collecting the views with intermediate amounts of motion around the central or zero phase encoding caused a lack of symmetry in the collected data. Certain spatial frequency components were selected preferentially as being less affected by motion in an asymmetric fashion. That is, negative high spatial frequencies were less affected while positive high spatial frequencies were more affected. This had an adverse effect on the point spread function and resolution of the resultant image. It was also a problem when a smoothing filter was applied because this filter rejected the negative highest spatial frequencies which contain the region of minimal motion (i.e. some of the best data is rejected).

Yet another difficulty resided in the one to one mapping by a probability distribution. Also, in certain patterns of breathing which had essentially no periods of rest, this data was not used most effectively. Further, the technique tended to misplace views near the center (i.e., violated the monotonically increasing function aspect) and hence the method was robust. Because significant motion may have occurred in the region of low spatial frequency where the signal power was the greatest, the image could still have singificant motion artifacts.

Memory limitations restrict the taking of multiple average and multiple slice data.

A futher disadvantage of the prior art was that any mapping or reordering of the phase encoding with the amplitude of the motion could not correct the motion. Because motion was not eliminated, an inherent loss of resolution resulted.

The present invention contemplates a new and improved phase encoding technique which overcomes the above referenced problems and others.

In accordance with one aspect of the present invention there is provided a method of magnetic resonance comprising: monitoring physical movement of at least a portion of a subject in an image region; exciting magnetic resonance of magnetic dipoles of at least a portion of the subject disposed in the image region; phase encoding magnetic field gradients in the image region with the selected phase encoding gradients; receiving resonance signals from the resonating dipoles in the image region; reconstructing an image representation of the portion of the subject in the image region from the resonance signals; and selecting a phase encoding gradient from a range of phase encoding gradients, which phase encoding gradient range includes a maximum phase encoding gradient, a minimum phase encoding gradient, and a multiplicity of phase encoding gradients therebetween including a central value; characterised in that the phase encoding gradient is selected in accordance with the physical movement such that during first periods of physical movement the selected encoding gradient is closest to the central value and during the second preselected periods of physical movement, the selected phase encoding gradient is distributed between the minimum and maximum phase encoding values.

In accordance with a second aspect of the present invention there is provided a magnetic resonance imaging apparatus comprising: a main magnetic field means for creating a main magnetic field through an image region; a magnetic resonance excitation means for exciting magnetic resonance of magnetic dipoles in the image region; a magnetic field gradient means for causing magnetic field gradients across the main magnetic field at least in the image region for at least phase encoding the magnetic resonance signals; at transform means for transforming resonance signals collected with each phase encoding gradient into an intermediate view; and a phase encoding gradient selection means for selecting a phase encoding gradient in accordance with physical movement of a portion of a subject in the image region; characterised by the phase encoding gradient means selecting a phase encoding gradient near a central value when the physical movement is adjacent one extreme movement and selecting a phase encoding gradient adjacent minimum and maximum phase encoding values when the monitored physical movement is adjacent a second extreme of movement, the phase encoding gradient selecting means being operatively connected with the magnetic field gradient means.

One magnetic resonance imaging method and apparatus in accordance with the invention will now be described by way of example with reference to the accompanying drawings in which:—

Figure 1 is a diagrammatic illustration of a magnetic resonance imaging apparatus in accordance with the present invention;

Figure 2 and 2A are graphic representations of a preferred centrally ordered phase encoding scheme in accordance with the present invention;

Figure 3 is a graphic illustration of an exemplary filter function for use in conjunction with the phase encoding scheme of Figure 2;

Figure 4 illustrates a scaling correction for respiratory motion;

Figure 5 illustrates a relationship between scaling correction and phase encoding gradients; and

Figure 6 is a graphic illustration of an alternate embodiment of a centrally ordered phase encoding scheme in accordance with the present invention.

Detailed Description of the Preferred Embodiments

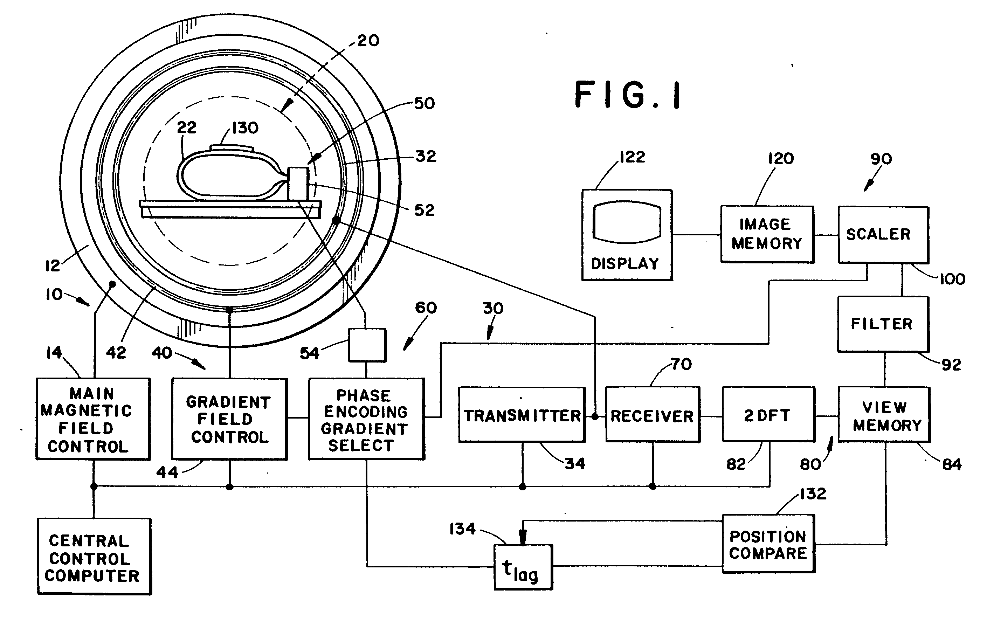

With reference to Figure 1, a main magnetic field generating means 10 generates a strong, generally uniform magnetic field which extends generally longitudinally through an image region 20. A resonance exicitation means 30 selectively excites magnetic dipoles of nuclei in the image region to precess about the main magnetic field. Each precessing magnetic dipole generates a component of a resonance signal.

A gradient field means 40 selectively causes gradients across the main magnetic field in the image region at selectable orientations. The gradient magnetic fields spatially encode the resonance signal components transmitted by the resonating dipoles within the image region. Specific to the preferred embodiment, the gradient magnetic fields encode spatial location along one axis in the frequency and encode spatial location along an orthogonal axis in the relative phase. The phase is encoded with one of the preselected set of phase encoding gradients. The set includes a central phase encoding gradient, preferably with zero value. The set extends through linearly incremented phase encoding gradients to a positive, maximum phase encoding gradient in one direction and to a negative phase encoding gradient in the other direction.

A monitoring means 50 monitors respiratory or other physical movement of a subject 22 in the image region 20. A phase encoding gradient selecting means 60 selects a phase encoding gradient from the preselected set in accordance with the monitored movement. Specifically, the selecting means selects a phase encoding gradient in accordance with the monitored physical movement such that during periods of least physical movement, the selected phase encoding gradient is closest to the central value; during the periods of greatest movement, the selected phase encoding gradient is distributed between the minimum and maximum values; and at intermediate ranges of movement, the selected phase encoding gradient is at proportionate intermediate values. Optionally, the selection criteria may be reversed such that the greatest movement is encoded at the central value and the least movement is encoded at the minimum and maximum values. Any spatial frequency region may be selected to have the least motion.

A sampling means 70 discretely samples an integral number of data points of received resonance signals each with a unique phase encoding gradient. A transform means 80 transforms or maps each resonance signal from data space or the phase/frequency domain into a view in image space or the spatial domain. A calibration means 90 adjusts or filters each view to emphasize views with the least motion; scales to compensate for motion, and/or a system non-linearities; and otherwise improve resolution or correct for distortion and artifacts. The views are summed in an image memory 120 to generated an image representation for display, storage, or further processing.

Although the preferred embodiment is described in conjunction with spin-echo two dimensional Fourier transform imaging, it is to be appreciated that the apparatus is applicable to hybrid imaging, echo planar imaging, projection reconstruction imaging, inversion recovery, saturation recovery, and other imaging techniques.

With continuing reference to Figure 1, the main magnetic field means 10 includes a plurality of annular super-conducting or fluid cooled high power mangets 12 for generating the main magnetic field axially therethrough. A main magnetic field control circuit 14 controls and applies appropriate electrical power to the annular magnets such that a substantially uniform constant magnetic field is generated longitudinally therebetween. Commonly, the main magnetic field has a frequency in the one 5—100 MHz range.

The excitation means 30 includes a coil 32 which is connected with a radio frequency transmitter 34 for broadcasting radio frequency excitation pulses. The radio frequency pulses are of the appropriate timing and duration, as it known in the art, to cause precession of the magnetic dipoles about the applied magnetic field. In the illustrated embodiment, the coil 32 functions between excitation pulses and an antenna for receiving the radio frequency resonance signals. Optionally, a separate pick-up coil assembly may be provided.

The gradient field means 40 includes gradient field coils 42 which surround the image region for selectively applying gradient magnetic fields transversely across the main magnetic field. A gradient magnetic field control circuit 44 controls the application of gradient fields. As is known in the art, the gradient fields encode spatial position in selected slices of the subject with appropriate frequency and phase encoding. The phase encoding gradient is encoded in accordance with the phase encoding gradient selected by the phase encoding gradient selection means 60.

The monitoring means 50 monitors the respiratory or other physical movement of the subject 22. In the preferred embodiment, the monitor means is a respiratory monitor 52 that includes a bellows arrangement to produce an output that varies in proportion to chest displacement. Preferably, a correlation adjustment means 54 allows the output signal of the mintor to be calibrated to the actual physical displacement of the subject undergoing examination. It should be recognized that other techniques are available which would allow the displacement to be monitored.

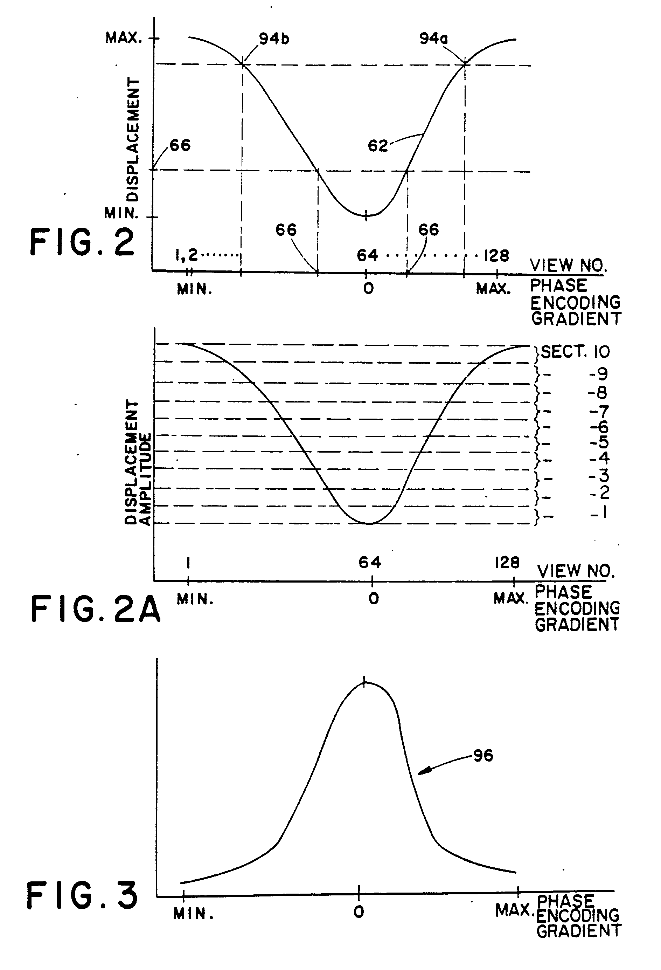

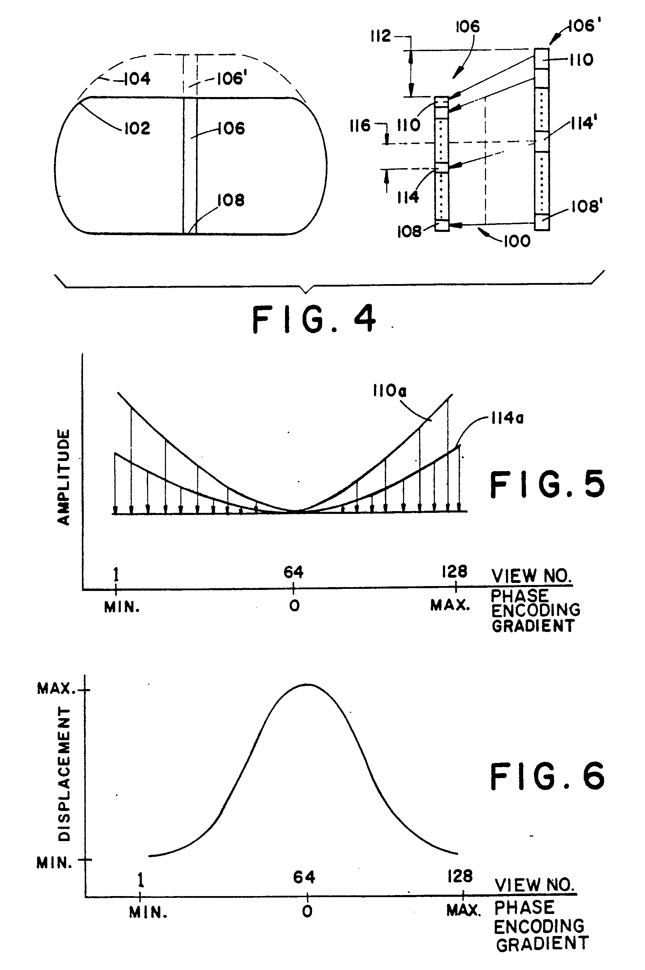

Ideally, a one-to-one mapping can be made from the monitored physical motion to the phase encoded gradients, such that a plot of phase encoded gradient value versus motion amplitude would yield a monotonically increasing function from the central value to the outer values (Figure 2). Optimally, if the region of interest is the high spatial frequencies, the mapping may show monotonically increasing values from the larger spatial frequencies to the center (Figure 6). Because the same motion amplitude occurs perodically, the correspondingly encoded view may already have been collected.

To accommodate potentially redundant motion amplitudes, the one-to-one mapping is divided into sections, e.g. ten sections or bands (Figure 2A). Each monitored amplitude retrieves the next available phase encoded gradient that corresponds to the band in which the monitored amplitude falls. This sectioning technique reduces memory requirements rendering it particularly advantageous in multiple slice and multiple averaging images.

With continuing reference to Figure 1 and particular reference to Figure 2, the phase selection means 60 selects the phase encoding gradient in accordance with the graphic display of Figure 2. That is, the physical displacement of the chest from the means correlation 54 indexes the corresponding displacement amplitude along the ordinate axis of Figure 2. The corresponding phase encoding gradient along the abscissa axis which is related by the illustrated curve 62 is selected to provide the phase encoding gradient of the gradient encoding for the next view. The phase selection means 60 includes a memory for remembering which phase encoded views have been taken so that the same phase gradient is not applied twice in one image. For example, the first time an exemplarly physical displacement 66 is addressed, a first phase encoding gradient 66a of the two possible views or phase encodient gradients is selected. The second time the same physical displacement 66 is addressed, the other corresponding phase encoding gradient or view 66b is selected. If the same displacement is addressed a third time, the most closely adjacent phase encodient gradient or view along the curve which has not yet been used in selected. Constraints can be applied which allows views associated with large amplitudes of motion to be selectively re-acquired. This allows a further improvement in resolution with a minimal, and if desired, fixed increase in time.

A further improvement in resolution can be obtained by interpolating each view of the data. The interpolation is based on the actual point to point movement, such as of the patient's chest. A spatial and or temporal model of the periodic motion may be developed. The interpolation is then selected in accordance with the motion as predicted by the model.

The sampling means 70 includes a receiver which receives the analog resonance signal that includes a large multiplicity of superimposed resonance signal components. The frequency and relative phase of each component is indicative of the encoded spatial position of the corresponding generating dipole. The receiver discretely samples each received resonance signal to generate one view of digital resonance signal data. Each view of data is two dimensionally transformed or mapped by a fast Fourier transform or other apprpriate transform (such as a generalized transform which may avoid or minimize errors due to interpolation) or reconstructing means 82 from the frequency and phase domain into a two dimensional spatial domain view which is stored in an intermediate memory means 84.

The calibration means 90 includes a filter means 92 for emphasizing the views taken with the phase encoding gradients which correspond to the least physical displacement, in the preferred embodiment the phase encoding gradients closest to the central phase encoding gradient. In the preferred embodiment, the filter means 92 includes a low pass filter which attenuates or eliminates views having a phase e.g. equivalent to spatial frequencies above or below preselected frequencies 94a and 94b of Figure 2. Optionally, a filter function 96, such as illustrated in Figure 3, may be utilized to emphasize views near the central phase encoding value and progressively de-emphasizes views at higher or lower phase encoding gradients.

A scaling means 100 shifts the pixels of each view in accordance with the degree of physical movement, e.g. respiratory displacement. In the preferred embodiment, the pixels are scaled or shifted in accordance with the amplitude of the motion at a given phase encoding gradient at which the view was taken.

With reference to Figure 4, the motion values from a first extreme or rest position 102 to a second extreme or maximum expansion position 104. A linear column of pixels 106 vertically through the center of the patient cyclically stretches from the rest position 106 to the expansion position 106'. The patient's back 108 remains stationary while a front or top portion 110 moves the farthest distance 112. Portions of the patient in between, such as central position 114, move a predictable intermediate distance 116.

Figure 5 illustrates the relationship between the phase encoding gradients and the effect relative shifting of typical pixels. Curve 110a illustrates the effective amplitude or vertical displacement correction for the pixel corresponding to the patient top portion 110. Curve 114a illustrates the effective amplitude or vertical displacement correction for the central pixel 114. The data in each pixel is analogously shifted downward to the rest or other selected position in accordance with the phase encoding gradient. For example, a phase encoding gradient which corresponds to 2 cm of movement of the upper chest may cause pixels along the top of the subject to be shifted downward by 2 cm, the pixels along the center pixel 114 to be shifted downward 1 cm, pixels at the bottom 108 to be unmoved, and proportionately for pixels in between.

Each of the filtered and scaled views is transformed and stored into the image memory 120. A video monitor 102 provides a man-readable display of the image. Optionally the image may be recorded on a tape or disk for later use or processing.

With reference to Figure 6, the phase selection means 60 may centrally order the phase encoding gradient of views with the greatest physical displacement. The minimal physical displacement is phase encoded with the maximum and minimum phase encoding gradients. With this alternate ordering, the filter means 92 includes a low pass filter or a filter which is the complement of Figure 3 for attenuating the central phase encoded gradient data relative to the phase encoded data collected at the phase encoding gradient extremes. Other phase encoding ordering may also be implemented as is appropriate to the data to be emphasized and de-emphasized.

Alternately, the motion sensing means 50 may sense the respiratory or other motion electronically. A control strip or member 130 of readily recognizable characteristics is positioned on the moving surface of the patient to be imaged therewith. A position comparing means 132 compares the relative position of the control strip 130 in each reconstructed view as it is received in the temporary memory means 82. The position of the central strip is, of course, indicative of the degree of respiratory expansion. Optionally, the comparing means may monitor a selected portion of the subject, such as the interface between the subject and the ambient atmosphere, heart wall portions or values, and the like. A time delay or movement compensating means 134 compensates for motion between the detection of the motion and the acquisition of the data. That is, the compensating means 134 multiplies the duration between the detection of the motion and the acquisition of the data by the speed with which the control member 130 is moving and adds this adjustment to the position determined by the position determing means 132. The phase encoding gradient selection means 60 selects the phase encoding gradient in accordance with the monitored physical position.

The invention has been described with reference to the preferred embodiment. Obviously, alterations and modifications will occur to others upon reading and understanding the preceding specification. It is intended that the invention be construed as including all such alterations and modifications in so far as they come within the scope of the appended claims.

**Claims**

1. A method of magnetic resonance imaging comprising: monitoring physical movement of at least a portion of a subject to an image region; exciting magnetic resonance of magnetic dipoles of at least a portion of the subject disposed in the image region; phase encoding magnetic field gradients in the image region with the selected phase encoding gradients; receiving resonance signals from the resonating dipoles in the image region; reconstructing an image representation of the portion of the subject in the image region from the resonance signals; and selecting a phase encoding gradient from a range of phase encoding gradients, which phase encoding gradient range includes a maximum phase encoding gradient, a minimum phase encoding gradient, and a multiplicity of phase encoding gradients therebetween including a central value; characterised in that the phase encoding gradient is selected in accordance with the physical movement such that during first periods of physical movement the selected phase encoding gradient is closest to the central value and during second preselected periods of physical movement, the selected phase encoding gradient is distributed between the minimum and maximum phase encoding values.

2. A method according to Claim 1 wherein the first preselected period is during respiratory relaxation and the second preselected period is during maximum respiratory inhalation.

3. A method according to Claim 1 wherein the phase encoding gradient selecting steps, the central phase encoding gradient is selected during periods of least physical movement, the minimum and maximum phase encoding gradients are selected during periods of greatest physical movement, and intermediate values are selected during proportionate intermediate degrees of physical movement between the least and most physical movement.

4. A method according to Claim 3 further including the step of reducing the effect of received resonance signals which are phase encoded with values adjacent the minimum and maximum phase encoding gradients in the reconstructed image representation.

5. A method according to Claim 1 wherein the reconstructing step includes reordering the received resonance signals into view representations and transforming the view representations into the image representation.

6. A method according to Claim 5 further including the step of scaling the physical position within each view to compensate for the physical motion such that the moving portions are shifted to a preselected position.

7. A method according to Claim 5 wherein the monitoring step is conducted electronically by measuring motion in each reconstructed view, such that the phase encoding gradient is selected from the measured motion in a preceding view.

8. A method according to Claim 7 further including the step of weighting views encoded adjacent the central phase encoding gradient more heavily and views collected adjacent the minimum and maximum phase encoding gradients less heavily when transforming the views to form an image representation.

9. A method according to Claim 6 further including scaling each view representation in accordance with the monitored physical movement to shift the moving subject portions of the view representations to a preselected subject position, whereby a first order correction to remove blurring from motion caused position indefiniteness is made.

10. A method according to Claim 9 further including the step of phase encoding magnetic field gradients in the image region with the selected phase encoding gradient, whereby a second order correction to remove motion related ghosting is made.

11. An apparatus for magnetic resonance imaging, the apparatus comprising: a main magnetic field means (10) for creating a main magnetic field through an image region (20); a magnetic resonance excitation means (30) for exciting magnetic resonance of magnetic dipoles in the image region (20); a magnetic field gradient means (40) for causing magnetic field gradients across the main magnetic field at least in the image region (20) for at least phase encoding the magnetic resonance signals; a transform means (82) for transforming resonance signals collected with each phase encoding gradient into an intermediate view; and a phase encoding gradient selection means (60) for selecting a phase encoding gradient in accordance with physical movement of a portion of a subject in the image region; characterised by the phase encoding gradient selecting means (60) selecting a phase encoding gradient near a central value when the physical movement is adjacent one extreme movement and selecting a phase encoding gradient adjacent minimum and maximum phase encoding values when the monitored physical movement is adjacent a second extreme of movement, the phase encoding gradient selecting means being operatively connected with the magnetic field gradient means.

12. An apparatus according to Claim 11 further including a monitoring means (50) for monitoring physical movement of at least a portion of a subject (22) within the image region (20), the monitoring means (50) being operatively connected with the phase encoding gradient selection means (60).

13. Apparatus according to Claim 12 wherein the monitoring means (50) includes means (52, 54, or 130) for monitoring a respiratory cycle of the subject and determining a degree of chest expansion between a minimum expansion extreme and a maximum chest expansion extreme.

14. An apparatus according to Claim 13 wherein the phase encoding gradient selection means (60) selects the central phase encoding gradient value at the minimum expansion extreme and selects the minimum and maximum phase encoding gradients at the maximum expansion extreme.

15. An apparatus according to Claim 14 further including a filter means (92) for weighting each intermediate view in accordance with the selected phase encoding gradient such that views encoded adjacent the central phase encoding gradient are weighted more heavily than views encoded adjacent the minimum and maximum phase encoding gradients and image memory means (120) for summing a plurality of the weighted views to form a image representation.

16. An apparatus according to Claim 11 further including a scaling means (100) for scaling data within each intermediate view for electronically shiting data from the moving subject portion into a preselected motion state, the scaling means (100) being operatively connected with the transforming means (82) and with the phase encoding gradient selection means (60).

17. An apparatus according to Claim 15 further including a filter means (92) for weighting each view in accordance with the selected phase encoding gradient and image memory means (120) for transforming a plurality of the weighted and scaled views to form an image representation.

18. An apparatus according to Claim 11 wherein the phase encoding gradient selection means (60) selects phase encoding gradients centrally within a range for movement adjacent a first portion and the apparatus includes filter means (92) which weights centrally encoding views most heavily such that the image representation emphasizes movement adjacent the first position.

19. An apparatus according to Claim 18 further including a scaling means (100) for spatially adjusting each view in accordance with the selected phase encoding gradient to compensate for the physical movement.

**Patentansprüche**

1. Verfharen zur magnetischen Resonanzabbildung, aufweisend: die Verfolgung körperlicher Bewegung von zumindest einem Teil eines Objekts in einem Bildbereich; die Anregung magnetischer Resonanz von magnetischen Dipolen zumindest eines Teils des im Bildbereich angeordneten Objekts; die Phasencodierung magnetischer Feldgradienten im Bildbereich mit den selektierten Phasencodierungsgradienten; das Empfangen von Resonanzsignalen von den resonierenden Dipolen im Bildbereich; das Rekonstruieren einer Bilddarstellung des Teils vom Objekt im Bildbereich aus den Resonanzsignalen; und das Selektieren eines Phasencodierungsgradienten aus einem Umfang von Phasencodierungsgradienten, welcher Phasencodierungsgradientenumfang einen Maximalphasencodierungsgradienten, einen Minimalphasencodierungsgradienten und eine Mehrzahl von Phasencodierungsgradienten dazwischen umfaßt, die einen Mittenwert einschließen; dadurch gekennzeichnet, daß der Phasencodierungsgradient entsprechend der körperlichen Bewegung derart selektiert wird, daß der selektierte Phasencodierungsgradient während erster Perioden der körperlichen Bewegung dem Mittenwert am nächsten ist und daß der selektierte Phasencodierungsgradient während zweiter vorselektierter Perioden körperlichen Bewegung zwischen dem Minimal- und Maximalphasencodierungswert verteilt ist.

2. Verfahren nach Anspruch 1, in welchem die erste vorselektierte Periode während der Atmungsentspannung vorliegt und die zweite vorselektierte Periode während maximaler Atmungsinhalation vorliegt.

3. Verfahren nach Anspruch 1, in welchem in den den Phasencodierungsgradienten selektierenden Schritten der zentrale Phasencodierungsgradient während Perioden geringster körperlicher Bewegung selektiert wird, der minimale und maximale Phasencodierungsgradient während Perioden größter körperlicher Bewegung selektiert werden und dazwischenliegende Werte während verhältnisgleicher Zwwischengrade körperlicher Bewegung zwischen der geringsten und stärksten körperlichen Bewegung selektiert werden.

4. Verfahren nach Anspruch 3, ferner umfassend den Schritt der Reduktion des Effekts empfangener Resonanzsignale, die mit an den minimalen und maximalen Phasencodierungsgradienten angrenzenden Werten phasencodiert sind, in der rekonstruierten Bilddarstellung.

5. Verfahren nach Anspruch 1, in welchem der Rekonstruktionsschritt die Rückordnung der empfangenen Resonanzsignale in Anschitsdarstellungen und die Transfromation der Ansichtsdarstellungen in die Bilddarstellung umfaßt.

6. Verfahren nach Anspruch 5, ferner umfassend den Schritt einer Skalierung der körperlichen Position innerhalb jeder Anschict zur Kompensation der körperlichen Bewegung in der Weise, daß die sich bewegenden Teile zu einer vorselektierten Position verschoben werden.

7. Verfahren nach Anspruch 5, in welchem der Verfolgungsschritt elektronisch durch Messen von Bewegung in jeder rekonstruierten Ansicht derart ausgeführt wird, daß der Phasencodierungsgradient aus der gemessenen Bewegung in einer vorausgehenden Ansicht selektiert wird.

8. Verfahren nach Anspruch 7, ferner umfassend den Schritt der stärkeren Wichtung von Ansichten, die angrezend an den zentralen Phasencodierungsgradienten codiert sind, und der weniger starken Wichtung von Ansichten, die angrezend an den minimalen und maximalen Phasencodierungsgradienten erfaßt sind, wenn die Ansichten zur Ausbildung einer Bilddarstellung transformiert werden.

9. Verfahren nach Anspruch 6, ferner umfassend die Skalierung jeder Ansichtsdarstellung entsprechend der verfolgten körperlichen Bewegung zur Verschiebung der sich bewegenden Objektteile der Ansichtsdarstellungen zu einer vorselektierten Objektsposition, wodurch eine Korrektur erster Ordnung zur Entfernung von Unschärfe aus bewegungsbedingter Positionsunklarheit gemacht wird.

10. Verfahren nach Anspruch 9, ferner umfassend den Schritt der Phasencodierung magnetischer Feldgradienten im Bildbereich mit dem selektrierten Phasencodierungsgradienten, wodurch eine Korrektur zweiter Ordnung zur Entfernung bewegungsbezogener Geisterbilder gemacht wird.

11. Vorrichtung zur magnetischen Resonanzabbildung, welche Vorrichtung aufweist: eine Grundmagnetfeldeinrichtung (10) zum Erzeugen eines Grundmagnetfeldes durch einen Bildbereich (20); eine magnetische resonanzanregende Einrichtung (30) zum Anregen magnetischer Resonanz von magnetischen Dipolen im Bildbereich (20); eine Magnetfeldgradienteneinrichtung (40) zum Hervorrufen von Magnetfeldgradienten durch das Grundmagnetfeld zumindest im Bildbereich (20) zumindest zur Phasencodierung der magnetischen Resonanzsignale; eine Transformationseinrichtung (82) zur Transformation von Resonanzsignalen, die mit jedem Phasencodierungsgradienten erfaßt werden, in eine Zwischenansicht; und eine Phasencodierungsgradientenselektionseinrichtung (60) zum Selektieren eines Phasencodierungsgradienten entsprechend der körperlichen Bewegung eines Teils eines Objekts im Bildbereich; gekennzeichnet durch die Phasencoiderungsgradientenselektionseinrichtung (60), die einen Phasencodierungsgradienten nahe eines zentralen Wertes selektiert, wenn die körperliche Bewegung nahe einer extremen Bewegung ist, und die einen Phasencodierungsgradienten angrenzend an minimale und maximale Phasencodierungswerte selektiert, wenn die verfolgte körperliche Bewegung an ein zweites Bewegungsextrem angrenzt, wobei die Phasencodierungsgradientenselektionseinrichtung betriebswirksam mit der Magnetfeldgradienteneinrichtung verbunden ist.

12. Vorrichtung nach Anspruch 11, ferner aufweisend eine Monitoreinrichtung (50) zur Verfolgung körperlicher Bewegung zumindest eines Teils eines Objekts (22) innerhalb des Bildbereichs (20), welche Monitoreinrichtung (50) betriebswirksam mit der Phasencodierungsgradientenselektionseinrichtung (60) verbunden ist.

13. Vorrichtung nach Anspruch 12, in welcher die Monitoreinrichtung (50) Einrichtungen (52, 54 oder 130) zum Verfolgen eines Atmungszyklus vom Objekt und zum Bestimmen eines Brustexpansionsgrades zwischen einem minimalen Expansionsextrem und einem maximalen Brustexpansionsextrem umfaßt.

14. Vorrichtung nach Anspruch 13, in welcher die Phasencodierungsgradientenselektionseinrichtung (60) den zentralen Phasencodierungsgradientenwert beim minimalen Expansionsextrem selektiert und die minimalen und maximalen Phasencodierungsgradienten beim maximalen Expansionsextrem selektiert.

15. Vorrichtung nach Anspruch 14, ferner aufweisend eine Filtereinrichtung (92) zum Wichten jeder Zwischenansicht entsprechend dem selektierten Phasencodierungsgradienten in der Weise, daß Ansichten, die angrenzend an den zentralen Phasencodierungsgradienten codiert sind, stärker gewichtet werden als Ansichten, die angrenzend an den minimalen und maximalen Phasencodierungsgradienten codiert sind, und eine Bildspeichereinrichtung (120) zum Summieren mehrerer der gewichteten Ansichten zur Ausbildung einer Bilddarstellung.

16. Vorrichtung nach Anspruch 11, ferner aufweisend eine Skalierungseinrichtung (100) zum Skalieren von Daten innerhalb jeder Zwischenansicht zur elektronischen Verschiebung von Daten vom sich bewegenden Objektteil in eine vorselektierte Bewegungsstellung, wobei die Skalierungseinrichtung (100) betriebswirksam mit der Transformationseinrichtung (82) und mit der Phasencodierungsgradientenselektionseinrichtung (60) verbunden ist.

17. Vorrichtung nach Anspruch 15, ferner aufweisend eine Filtereinrichtung (92) zum Wichten jeder Ansicht entsprechend dem selektierten Phasencodierungsgradienten und eine Bildspeichereinrichtung (120) zur Transformation mehrerer der gewichteten und skalierten Ansichten zur Ausbildung einer Bilddarstellung.

18. Vorrichtung nach Anspruch 11, in welcher die Phasencodierungsgradientenselektionseinrichtung (60) die Phasencodierungsgradienten innerhalb eines Bewegungsbereichs angrenzend an eine erste Position zentral selektiert und die Vorrichtung eine Filtereinrichtung (92) aufweist, die zentralcodierte Ansichten derart am stärksten wichtet, daß die Bilddarstellung an die erste Position angrenzende Bewegung betont.

19. Vorrichtung nach Anspruch 18, ferner aufweisend eine Skalierungseinrichtung (100) zum räumlichen Anpassen jeder Ansicht entsprechend dem selektierten Phasencodierungsgradienten zur Kompensation der physikalischen Bewegung.

**Revendications**

1. Procédé de formation d'image par résonance magnétique, comprenant le contrôle du mouvement physique d'au moins une partie d'un sujet dans une région de formation d'image, l'excitation de la résonance magnétique des dipôles magnétiques d'une partie au moins du sujet diposé dans la région de formation d'image, le codage du phase de gradients de champ magnétique dans la région de formation d'image avec des gradients choisis de codage de phase, la réception de signaux de résonance des dipôles qui résonnent dans la région de formation d'image, la reconstitution d'une représentation d'image de la partie du sujet se trouvant dans la région de formation d'image à partir des signaux de résonance, et la sélection d'un gradient de codage de phase d'après une gamme de gradients de codage de phase, la gamme de gradients de codage de phase et plusieurs gradients intermédiaires de codage de phase comprenant un gradient maximal de codage de phase, un gradient minimal de codage de phase comprenant une valeur centrale, caractérisé en ce que le gradient de codage de phase est choisi en fonction du mouvement physique de mainère que, pendant les premières périodes du mouvement physique, le gradient de codage de phase que est choisi soit le plus proche de la valeur centrale et que, pendant des secondes périodes prédéterminées de mouvement physique, le gradient choisi de codage de phase soit réparti entre les valeurs minimale et maximale de codage de phase.

2. Procédé selon la revendication 1, dans lequel la première période choisie préalablement correspond à la relaxation respiratoire et la seconde période choisie préalablement correspond à l'aspiration respiratoire maximale.

3. Procédé selon la revendication 1, dans lequel, pendant les étapes de sélection de gradients de phase, le gradient de codage de phase est sélectionné pendant les périodes de moindre mouvement physique, les gradients minimal et maximal de codage de phase sont sélectionnés pendant les périodes de plus grand mouvement physique, et des valeurs intermédiaires sont choisies pour des degrés intermédiaires proportionnels de mouvement physique entre le plus petit et le plus grand mouvement physique.

4. Procédé selon la revendication 3, comprenant en outre l'étape de réduction de l'effet des signaux reçus de résonance qui sont codés en phase à l'aide de valeurs adjacentes des gradients minimal et maximal de codage de phase dans la représentation de l'image reconstituée.

5. Procédé selon la revendication 1, dans lequel l'étape de reconstitution comprend le réarrangement des signaux reçus de résonance en représentations de vues et la transformation des réprésentation de vues en représentation d'image.

6. Procédé selon la revendication 5, comprenant en outre une étape de changement d'échelle de la position physique dans chaque vue afin que le mouvement physique soit compensé d'une manière telle que les parties mobiles sont décalées vers une position prédéterminée.

7. Procédé selon la revendication 5, dans lequel l'étape de contrôle est réalisée électroniquement par mesure du mouvement dans chaque vue reconstituée, si bien que le gradient de codage de phase est sélectionné d'après le mouvement mesuré dans une vue précédente.

8. Procédé selon la revendication 7, comprenant l'étape de pondération plus importance des vues codées proches du gradient central de codage de phase et la pondération moins importante de vues collectées près des gradients minimal et maximal de codage de phase lors de la transformation des vues pour la formation d'une représentation d'image.

9. Procédé selon la revendication 6, comprenant en outre le changement d'échelle de chaque représentation de vue en fonction du mouvement physique contrôlé afin que les parties mobiles du sujet des représentations de vues soient déplacées vers une position prédéterminée du sujet, si bien qu'une correction du premier ordre est réalisée afin qu'elle supprime le voile du au défaut de définition de la position dû au mouvement.

10. Procédé selon la revendication 9, comprenant en outre l'étape de codage de la phase des gradients de champ magnétique dans la région de formation de l'image avec un gradient sélectionné de codage de phase afin qu'une correction du second ordre réalisée et supprime le fantôme relatif au mouvement.

11. Appareil de formation d'image par résonance magnétique, l'appareil comprenant un dispositif (10) de création d'un champ magnétique principal destiné à créer un champ magnétique principal dans une région de formation d'image (20), un dispositif (30) d'excitation de résonance magnétique destiné à exciter la résonance magnétique des dipôles magnétiques dans la region de formation d'image (20), un dispositif (40) destiné à provoquer la création de gradients de champ magnétique dans le champ magnétique principal au moins dans la région de formation d'image (20) pour le codage de la phase au moins des signaux de résonance magnétique, un dispositif (82) de transformation des signaux de résonance collectés avec chaque gradient de codage de phase en une vue intermédiaire, et un dispositif (60) de sélection d'un gradient de codage de phase en fonction du mouvement physique d'un partie du sujet dans la région de formation d'image, caractérisé en ce que le dispositif (60) de sélection de gradients de codage de phase sélectionne un gradient de codage de phase proche d'une valeur centrale lorsque le mouvement physique est adjacent à un mouvement extrême et sélectionne un gradient de codage de phase adjacent à des valeurs minimale et maximale de codage de phase lorsque le mouvement physique contrôlé est adjacent à une seconde extrémité du déplacement, le dispositif de sélection de gradients de codage de phase étant raccordé au dispositif de création d'un gradient de champ magnétique.

12. Procédé selon la revendication 11, comprenant en outre un dispositif (50) de contrôle du mouvement physique d'une partie au moins d'un sujet (22) placée dans la région de formation d'image (20), le dipositif de contrôle (50) étant raccordé au dispositif (60) de sélection de gradients de codage de phase.

13. Appareil selon la revendication 12, dans lequel le dispositif de contrôle (50) comporte un dispositif (52, 54 ou 130) destinée à contrôler un cycle respiratoire du sujet et à déterminer un degré de dilatation du thorax entre une extrémité de dilatation minimale et une extrémité de dilatation maximale du thorax.

14. Appareil selon la revendication 13, dans lequel le dispositif (60) de sélection de gradients de phase sélectionne la valeur centrale du gradient de codage de phase pour l'extrémité correspondant à une expansion minimale et sélectionne les gradients minimal et maximal de codage de phase à l'extrémité correspondant à une expansion maximale.

15. Appareil selon la revendication 14, comprenant en outre un dispositif (92) de filtrage pour pondérer chaque vue intermédiaire selon le gradient de codage de phase choisi, de manière que des vues codées près du gradient de codage de phase centrale, fassent l'objet d'un coefficient de pondération plus fort que celui de vues codées près des gradients minimal et maximal de codage de phase, et un dispositif (120) de mise en mémoire d'images pour faire la somme de plusieurs vues pondérées afin de former une représentation d'image(s).

16. Appareil selon la revendication 11, comprenant en outre un dispositif (100) de changement d'échelle pour mettre à l'échelle ou modifier l'échelle de données au sein de chaque vue intermédiaire pour décaler électroniquement des données de la partie du sujet en mouvement vers un état de mouvement choisi à l'avance, le dispositif (100) de changement d'échelle étant relié au dispositif (82) de transformation de signaux et au dispositif (60) de sélection de gradients de codage de phase.

17. Appareil selon la revendication 15, comprenant en outre un dispositif (92) de filtrage pour pondérer chaque vue an fonction du gradient choisi de codage de phase et un dispositif (120) de mise en mémoire d'image(s) pour transformer plusieurs des vues pondérées et mises à l'échelle afin de former une représentation d'images.

18. Appareil selon la revendication 11, dans lequel le dispositif (60) de sélection de gradients de codage de phase sélectionne des gradients de codage de phase dans la partie central d'une gamme pour tenir compte du mouvement près d'une première position, et l'appareil comprend un dispositif (82) de filtrage qui accorde un plus grand coefficient de pondération à des vues de codage en partie centrale, de sorte que la représentation de l'image souligne le mouvement près de la première position.

19. Appareil selon la revendication 18, comprenant en outre un dispositif (100) de changement d'échelle pour ajuster dans l'espace chaque vue selon le gradient choisi pour le codage de phase afin de compenser le mouvement physique.

FIG.1

FIG. 2

FIG. 2A

FIG. 3

2

FIG. 4

FIG. 5

FIG. 6